# EUROPÄISCHE PATENTSCHRIFT

(11) **EP 2 041 638 B1**
(45) Veröffentlichungstag und Bekanntmachung des Hinweises auf die Patenterteilung: **16.09.2009**
(21) Anmeldenummer: 07801157.4
(22) Anmeldetag: 12.07.2007
(51) Int. Cl.: G06F 1/20

(54) **KÜHLVORRICHTUNG**
COOLING DEVICE
DISPOSITIF DE REFROIDISSEMENT

(30) Priorität: 14.07.2006 DE 102006033030
(43) Veröffentlichungstag der Anmeldung: 01.04.2009
(73) Patentinhaber: Janz Informationssysteme AG, 33100 Paderborn (DE)
(72) Erfinder: LOCKMANN, Arnulf, 33102 Paderborn (DE)
(74) Vertreter: Holland, Ralf
(86) Internationale Anmeldenummer: PCT/DE2007/001261
(87) Internationale Veröffentlichungsnummer: WO 2008/006362

(56) Entgegenhaltungen:
- US-A1- 2004 160 741
- US-A1- 2005 241 803
- US-A1- 2006 161 311

## Beschreibung

Die Erfindung betrifft eine kühlmittelgekühlte, insbesondere flüssigkeitsgekühlte Kühlvorrichtung für Computer, Computerracks, Computerräume oder dergleichen, aufweisend wenigstens einen Kühlkreislauf.

Im Gegensatz zu herkömmlichen PC's, deren Netzteile regelmäßig über eine Leistung von ca. 300 W bis 400 W verfügen, benötigen heutige Hochleistungs-Server Netzteile, die mit etwa 1400 W deutlich mehr leisten.

Aufgebaut in Racks können damit mehrere Highend-Server und Speicher-Subsysteme heute Wärmelasten von bis zu 18 kW/m² Stellfläche erzeugen. Der Trend zu immer höherer Leistung bei immer kleineren Gehäusemaßen setzt sich dabei fort, weshalb Wärmelasten von mehr als 18 kW/m² in unmittelbarer Zukunft abgeführt werden müssen, damit die elektrischen und elektronischen Geräte bei einer optimalen Temperatur zwischen 18°C und 20°C betrieben werden können.

Werden übliche PC's zumeist durch eingebaute Lüfter gekühlt, sind diese für Hochleistungs-Server wenig geeignet, da die Lüfterkapazität regelmäßig für eine Kühlung nicht ausreichend ist und insbesondere die Wärme in der Umgebung der Geräte verbleibt. Im Stand der Technik erfolgt deshalb bei Hochleistungs-Rechenanlagen häufig eine Kühlung in Form einer Raumkühlung durch eine Klimaanlage. Neben auftretenden Problemen bei der Luftzirkulation kann durch eine derartige Klimatisierung beispielsweise eines Serverraums kaum mehr als 1 kW/m² an Wärme regelmäßig abgeführt werden.

Da die Leistungsgrenzen solcher konventioneller Kühlungstechniken erreicht sind, erfolgt zunehmend eine Flüssigkeitskühlung, die zum einen eine direkte Kühlung elektronischer Bauteile ermöglicht, insbesondere der CPU's als Beispiel sogenannter Hot Spots. Infolge dieser Maßnahme erfolgt eine unmittelbare Kühlung an den wärmeerzeugenden Elementen, was eine kleinere Ausbildung der Kühlkörper eines Servers bedeuten kann. Als nachteilig ist dabei jedoch anzusehen, dass eine Kühlflüssigkeit unmittelbar in elektrische und elektronische Geräte eingebracht werden muss. Bei einer Leckage würden diese regelmäßig zerstört werden. Auch ist ein Anschluss an einen Kühlmittelkreislauf nicht unproblematisch, da Server regelmäßig aus Racks ausziehbar in diese eingebracht sind.

Zum anderen kann eine Kühlung, insbesondere auch eine Flüssigkeitskühlung der Racks erfolgen, durch welche Maßnahme die elektronischen Bauteile vor einer Leckage eines Kühlkreislaufs weitgehend geschützt sind, wenn entsprechende Führungen der Kühlkreisläufe in den Racks vorhergesehen werden.

Vor diesem technischen Hintergrund macht die Erfindung es sich zur Aufgabe, die zukünftig regelmäßig nötig werdenden kühlmittelgekühlten, insbesondere flüssigkeitsgekühlten Kühlvorrichtungen dahingehend auszugestalten, dass diese mit einem Höchstmaß an Sicherheit betrieben werden können und so auch ein Höchstmaß an Sicherheit für die gekühlten elektrischen und elektronischen Bauteile gewährleisten. Damit einhergehend wird auch die Sicherheit der peripheren elektrischen/elektronischen Geräte wie Speicherbänke, Netzteile, Festplatten oder dergleichen deutlich erhöht.

Gelöst wird diese technische Problematik bei einer kühlmittelgekühlten Kühlvorrichtung für Computer, Computerracks, Computerräume oder dergleichen, aufweisend wenigstens einen Kühlkreislauf, gemäß des Anspruchs 1 durch die Maßnahmen, dass in dem Kühlkreislauf eine Drucksenke angeordnet ist und dass der Kühlkreislauf mit einem gegenüber dem Außendruck der Umgebung geringeren Arbeitsdruck beaufschlagt ist.

Ist, wie bevorzugt, der Kühlkreislauf geschlossen gehalten, bedarf es regelmäßig nur einer geringen Menge eines Kühlmittels wie einer Kühlflüssigkeit. Da jedoch die Kühlvorrichtung nach der Erfindung geeignet ist, neben einer Raumkühlung auch eine Rack- und sogar eine unmittelbare Kühlung von elektronischen Bauteilen zu ermöglichen, wird als weitere Sicherheitsmaßnahme in dem Kühlkreislauf eine Drucksenke angeordnet und ist der Kühlkreislauf mit einem gegenüber dem Aussendruck der Umgebung geringeren Arbeitsdruck beaufschlagt. Bei einer Leckage des Kühlkreislaufs wird, zumindest über eine gewisse Zeit, kein Kühlmittel austreten. Vielmehr kann durch geeignete Maßnahmen sichergestellt werden, dass ein Druckanstieg innerhalb des Kühlkreislaufes schnell und sicher erkannt wird, da solches auf eine Leckage hinweist. Geeignete Sicherheitsvorkehrungen können dann noch rechtzeitig getroffen werden, beispielsweise kann eine Abschaltung der Gesamtsysteme erfolgen. Von Vorteil ist hierbei weiter, dass ein Druckanstieg innerhalb des Kühlkreislaufes mit höherer Sicherheit erfasst werden kann als ein Druckabfall bei einer Leckage eines mit einem gegenüber dem Aussendruck höheren Arbeitsdruck betriebenen Kühlkreislaufs.

Alternativ oder zusätzlich, insbesondere auch für die Nachrüstung bereits vorhandener, vorzugsweise flüssigkeitsgekühlter Kühlvorrichtungen geeignet, kann gemäß des Anspruchs 2 vorgesehen sein, dass in dem Kühlkreislauf eine öffenbare Drucksenke angeordnet ist und dass die Drucksenke derart bemessen ist, dass durch sie im Fall einer Leckage des Kühlkreislaufs das Kühlmittel wie eine Kühlflüssigkeit aus dem Kühlkreislauf abgezogen wird.

Auch bei dieser Variante ist bevorzugt der Kühlkreislauf geschlossen. Sollte ein offener Kühlkreislauf Verwendung finden, sollte die Abflussmenge des Kühlmittels gering nur bemessen sein.

Wird eine Leckage innerhalb des Kühlkreislaufes, unabhängig von seiner Druckbeaufschlagung, festgestellt, wird die Drucksenke geöffnet, beispielsweise ein Ventil einer Vakuumkammer, deren Volumen derart bemessen ist, dass sie bei einer,Leckage das Kühlmittel des Kühlkreislaufs weitestgehend aus dem Kühlkreislauf abziehen und auch aufnehmen kann, so dass kaum Kühlmittel aus dem Kühlkreislauf durch ein Leck austritt.

In konstruktiver Ausgestaltung der Kühlvorrichtungen nach der Erfindung ist vorgesehen, dass der Kühlkreislauf ein Sekundärkreislauf ist, dessen Wärme über einen Wärmetauscher und einen Primärkreislauf abgeführt wird. Infolgedessen brauchen bei dem sekundären Kühlkreislauf nur geringe Wärmemengen regelmäßig gehandhabt zu werden, womit auch die Menge des Kühlmittels gering gehalten werden kann. Abgeführt wird die Wärme des Kühlkreislaufs über den Primärkreislauf, der nahezu beliebig ausgestaltet sein kann und an den durchaus auch mehrere Sekundärkreisläufe parallel noch angeschlossen sein können. Damit kann die Abwärme gegebenenfalls auch sinnvoll anderen Verwendungszwecken zugeführt werden.

In weiterer konstruktiver Ausgestaltung der Kühlvorrichtung nach der Erfindung ist vorgesehen, dass das Druckpotential der Drucksenke von einer Pumpe aufrechterhalten wird. Es ist hierdurch sichergestellt, dass die Drucksenke und insbesondere auch der Kühlkreislaufs der Kühlvorrichtung nach der Erfindung auf einem Unterdruck gegenüber dem Umgebungsdruck gehalten ist.

Für das Durchströmen des Kühlmittels durch den Kühlkreislauf ist in diesem wenigstens eine weitere Pumpe vorgesehen, wobei deren Druckaufbau derart bemessen ist, dass die Druckdifferenz zwischen der Umgebung und dem Kühlkreislauf zwischen 100 mbar und 300 mbar beträgt und/oder dass der Maximaldruck noch deutlich unter dem Umgebungsdruck, bevorzugt unter 0,8 bar gehalten ist.

In konstruktiver Ausgestaltung der Kühlvorrichtung nach der Erfindung ist vorgesehen, dass für einen Wärmeübergang von einem Computer, einem Computerrack, einem Computerraum oder dergleichen mehrere Wärmetauscher vorgesehen sind und dass die Wärmetauscher parallel von dem Kühlmittel durchströmt werden. Solche insbesondere sich flächenhaft erstreckende Wärmetauscher können zwischen den zu kühlenden Komponenten innerhalb eines Racks bspw. auch angeordnet werden. Dies weist darüber hinaus den Vorteil auf, dass ein an einem Rack aufsteigender Luftstrom in unterschiedlichen Höhen mehrfach gekühlt wird.

Stromauf der Wärmetauscher ist bevorzugt eine kaskadenartige Verteilvorrichtung angeordnet ist, durch die sichergestellt wird, dass ein jeder einen Wärmetauscher aufweisender Strang gleichermaßen mit dem Kühlmittel beaufschlagt wird.

Es kann stromab der Wärmetauscher in einem den Wärmetauschern gemeinsamen Strang des Rücklaufs eine Pumpe angeordnet sein, die gleichsam die Kühlflüssigkeit durch die Wärmetauscher zieht. Dieser Effekt kann durch unterschiedliche Querschnitte der Leitungen noch verstärkt werden, wobei der Querschnitt stromab der Wärmetauscher der größere ist.

Zweckmäßigerweise wird bei einer Leckage ein Druckanstieg in dem Kühlkreislauf von einer Überwachungsvorrichtung festgestellt, woraufhin von der Überwachungsvorrichtung die Pumpen stromauf des Lecks in dem Kühlkreislaufs abgeschaltet werden, die Pumpen stromab des Lecks in dem Kühlkreislauf jedoch weiterlaufen, bis das Kühlmittel in dem Kühlkreislauf abgezogen ist. Aufgrund dieser Maßnahmen wird das Kühlmittel nahezu vollständig abgezogen. Zu einem nennenswerten Austritt des Kühlmittels aus dem Kühlkreislauf kommt es nicht, da auch stromauf der abgeschalteten Pumpen die Drucksenke aus diesem Zweig des Kühlkreislaufs Kühlmittel bei abgeschalteten Pumpen abziehen wird.

Bevorzugt beträgt die Vorlauftemperatur des Kühlmittels 13°C bis 15°C und die Rücklauftemperatur zwischen 19°C und 21°C. Eine optimale Betriebstemperatur von 18°C bis 20°C kann mit diesen Temperaturwerten problemlos eingehalten werden, wenn eine ausreichende Wärmekapazität des Kühlkreislaufs vorgesehen ist. Ist jedoch an eine unmittelbare Kühlung der sogenannten Hot Spots gedacht, die Temperaturen von ca. 70°C regelmäßig aufweisen, kann auch eine erhöhte Rücklauftemperatur zwischen 40°C und 50°C zweckmäßig sein, die bspw. als Prozesswärme weiter genutzt werden kann.

Es kann vorgesehen sein, dass das Kühlmittel ein Gas ist, insbesondere ein Inertgas. Jedoch ist die Wärmekapazität von Gasen regelmäßig gering, so dass bevorzugt wird, dass das Kühlmittel in einer flüssigen Phase vorliegt, bspw. in Form von Wasser.

Insbesondere dann wird weiter bevorzugt vorgesehen, dass das in einer flüssigen Phase vorliegende Kühlmittel entgast ist. Ansonsten können in dem Kühlmittel auftretende Gasblasen zu Kavitationseffekten an den Pumpen beispielsweise führen. Hierbei kann an eine Entgasung vor dem Einbringen des Kühlmittels in die Kühlvorrichtung nach der Erfindung gedacht sein oder auch an eine Entgasung permanent oder intervallartig während des Betriebs.

Es kann hierzu ferner zweckmäßig sein, dass in einem Gasraum über dem Kühlmittel innerhalb der Drucksenke wenigstens ein Kältepol angeordnet ist. Beispielsweise einfach ausgeführt als ein gekühlter Blechstreifen, als Peltier-Element ausgeführt oder dergleichen mehr. Ein solcher der Entgasung dienender Kältepol wird regelmäßig von Eis überzogen, so dass vorzugsweise zwei Kältepole wechselweise betrieben werden, so dass sich an einem Kältepol immer Feuchtigkeit ablagern kann.

Die Temperatur des Kältepols sollte dabei zwischen -20°C und -30°C aufweisen.

Die Kühlvorrichtung nach der Erfindung wird anhand der Zeichnung näher erläutert, in der lediglich schematisch ein Ausführungsbeispiel dargestellt ist. In der Zeichnung zeigt:
- Fig. 1:: einen Kühlkreislauf einer Kühlvorrichtung nach der Erfindung,
- Fig. 2:: den Druckverlauf über den Kühlkreislauf und
- Fig. 3:: eine Variante eines Kühlkreislaufs.

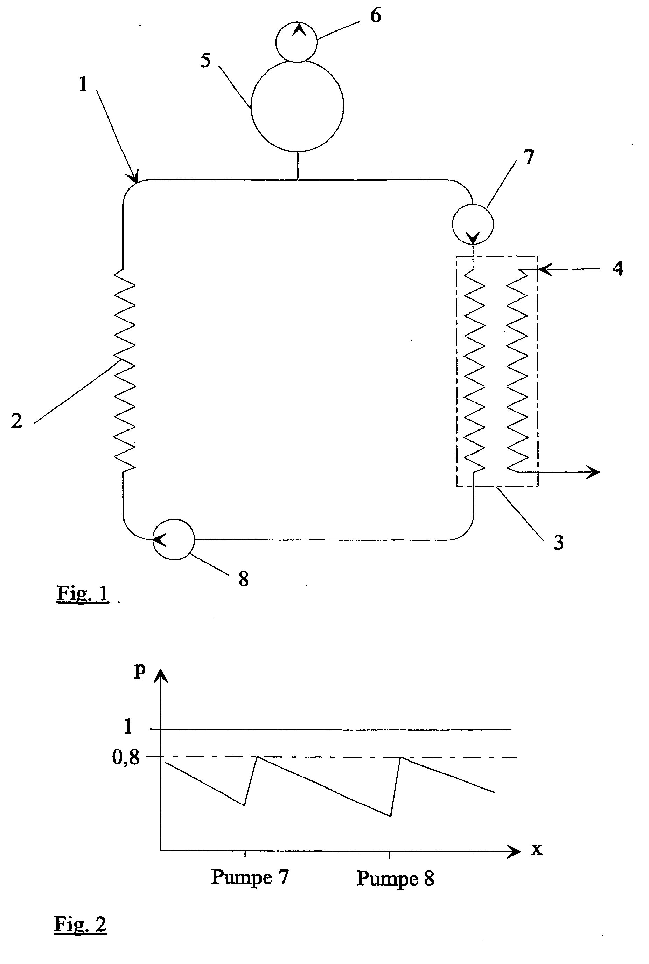

Figur 1 zeigt einen als Sekundärkreislauf ausgebildeten, geschlossenen Kühlkreislauf 1. In dem Kühlkreislauf 1 ist ein Luft/Kühlmittel-Wärmetauscher 2 eingebracht, über den beispielsweise die Wärme aus einem Serverraum abgeführt wird.

Zusätzlich oder alternativ kann der Kühlkreislauf 1 auch - dahingehend ausgelegt sein, dass beispielsweise Computerracks und/oder elektronische Komponenten eines Computers unmittelbar gekühlt werden.

Die auf den Kühlkreislauf 1 übergegangene Wärme wird über einen zweiten Kühlmittel/Kühlmittel-Wärmetauscher 3 und einen nahezu beliebig gestaltbaren, primären Kühlkreislauf 4 abgeführt.

In dem Kühlkreislauf 1 ist eine Drucksenke 5 angeordnet, deren Volumen und Unterdruck so bemessen ist, dass bei einer Leckage das Kühlmittel innerhalb des Kühlkreislaufs 1 weitestgehend aufgenommen werden kann. Bei der Drucksenke 5 kann es sich um einen Unterdruck- oder ein Vakuumgefäß handeln.

Ist eine solche Drucksenke, insbesondere ein Vakuumgefäß an einen herkömmlichen Kühlkreislauf nach dem Stand der Technik über ein Ventil angeschlossen, wird das Ventil der Drucksenke im Falle einer Leckage in dem Kühlkreislauf geöffnet und wird die Drucksenke das in dem Kühlkreislauf befindliche Kühlmittel weitestgehend abziehen, womit ein hoher Sicherheitsstandard gewährleistet ist.

Ist wie bei dem Ausführungsbeispiel vorgesehen, dass der Betriebsdruck des Kühlkreislaufs 1 geringer bemessen ist als der Umgebungsdruck, wird die Drucksenke 5 mittels einer Pumpe 6 evakuiert und der Druck innerhalb des Kühlkreislaufs 1 unterhalb des Umgebungsdrucks gehalten. Innerhalb des Kühlkreislaufs 1 können weitere Pumpen 7,8 angeordnet sein, die den für ein Strömen des Kühlmittels nötigen Differenzdruck innerhalb des Kühlkreislaufs 1 erzeugen.

Dies ist in dem Diagramm gemäß Figur 2 dargestellt, das sehr schematisch den Druckverlauf p über dem Weg x des Kühlkreislaufs 1 darstellt. Eingetragen ist dort als obere horizontale Linie der Umgebungsdruck in einer Größenordnung von 1,0 bar. Der maximale Betriebsdruck in dem Kühlkreislauf 1 beträgt vorzugsweise etwa 0,8 bar, angedeutet durch die strichlinierte Linie, der durch die Pumpen 7,8 aufgebaut wird.

Die Pumpen 7,8 erhöhen den Betriebsdruck innerhalb des Kühlkreislaufs 1 nach Druckabfall beispielsweise an den Wärmetauschern 2,3, bevorzugt maximal bis auf den Wert von etwa 0,8 bar.

In der Zeichnung nicht dargestellt ist die Möglichkeit, eine Überwachungsvorrichtung in dem Kühlkreislauf 1 vorzusehen, die über Drucksensoren oder dergleichen bei einer Leckage des Kühlkreislaufs 1 einen Druckanstieg feststellt. Die Überwachungsvorrichtung wird im Falle einer solchen Leckage beispielsweise zwischen den Pumpen 7,8 die Pumpe 7 stromauf des Lecks in dem Kühlkreislauf 1 abschalten. Die Pumpe 8 stromab des Lecks in dem Kühlkreislaufs 1 wird allerdings weiterlaufen, bis das verbleibende Kühlmittel in die Drucksenke 5 abgezogen ist. Auch die Pumpe 6 der Drucksenke wird weiterlaufen und das niedrige Druckniveau innerhalb des Kühlkreislaufs 1 versuchen aufrechtzuerhalten. Infolge dieser Maßnahmen wird aus dem Leck des Kühlkreislaufs 1 kaum Kühlmittel austreten. Ist das Kühlmittel dann in der Drucksenke 5 gesammelt, wird sich der Kühlkreislauf 1 insgesamt ausschalten.

Um eine Höchsttemperatur beispielsweise in einem Serverraum zwischen 18°C und 20°C sicherzustellen, sollte die Vorlauftemperatur zwischen 13°C und 15°C betragen, insbesondere bei den hier beispielhaft erwähnten Betriebsparametern 14°C, so dass die Vorlauftemperatur oberhalb des Taupunkts liegt. Die Rücklauftemperatur entsprechend zwischen 19°C und 21°C. Eine optimale Betriebstemperatur für elektrische und elektronische Geräte wie Server, Computer oder dergleichen ist damit gegeben.

Bevorzugt wird ferner, dass das Kühlmittel in einer flüssigen Phase vorliegt. Dabei ist jedoch beachtlich, dass innerhalb des Kühlkreislaufs 1 der Dampfdruck nicht unterschritten wird. Wasser hat sich als Kühlmittel in derartigen Kühlvorrichtungen als durchaus verwendbar erwiesen.

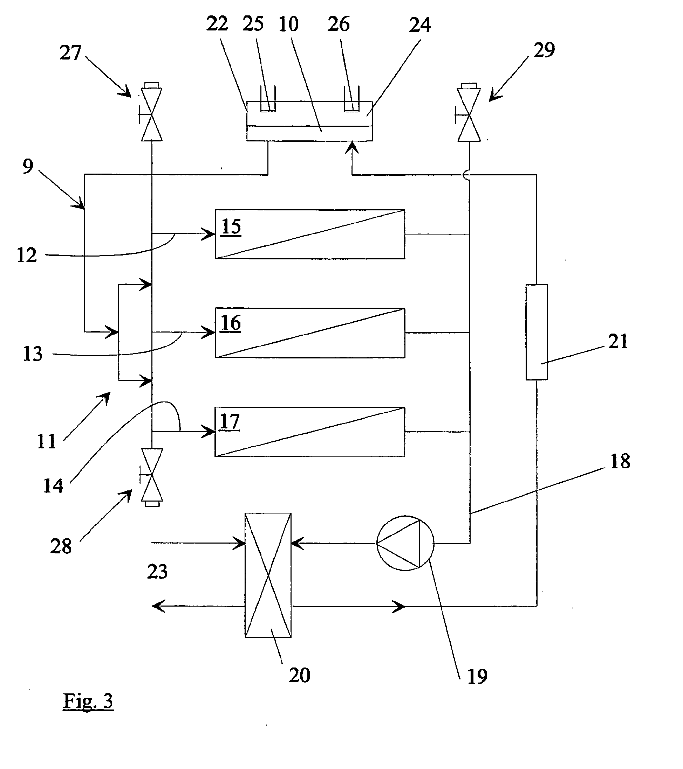

Bei dem Ausführungsbeispiel gemäß Figur 3 ist ein Kühlkreislauf 9 konventionell aus Kupferrohren für ein Kühlmittel 10 aufgebaut, beispielsweise von einem Durchmesser von % Zoll. Der Kühlkreislauf 9 wird kaskadenartig in einer Verteilvorrichtung 11 auf drei parallele Stränge 12-14 aufgeteilt, die jeweils einen Wärmetauscher 15-17 aufweisen. Stromab der Wärmetauscher 15-17 wird das Kühlmittel 10, vorzugsweise Wasser, in einem gemeinsamen Strang 18 des Rücklaufs einer Pumpe 19 zugeführt, die ausreichend bemessen ist, die Druckdifferenz für den Durchfluss des Kühlmittels 10 sicher zu stellen.

Über einen weiteren Wärmetauscher 20 und einen Durchflussmengenzähler 21 wird von der Pumpe 19 das Kühlmittel 10 in einen Unterdruckbehälter 22 gepumpt.

Dem System wird Wärme über den Kühlkreislauf 23 des Wärmetauschers 20 entzogen. Werden innerhalb des Kühlkreislaufs 9 sogenannte Hot Spots gekühlt, die Temperaturen von 70° aufweisen können, so kann die Rücklauftemperatur des Kühlmittels 10 im Wärmetauscher 20 durchaus zwischen 40° und 50° betragen, so dass die im Kühlkreislauf 23 abgeführte Wärme als Prozesswärme auch beispielsweise genutzt werden kann.

Der Unterdruckbehälter 22 dient als Drucksenke, durch die der Druck in der Kühlvorrichtung unter dem Umgebungsdruck und insbesondere auch unter einem Druck von 0,8 bar gehalten wird. Hierzu kann, nicht dargestellt, der Unterdruckbehälter 22 permanent oder bei Bedarf mittels einer Vakuumpumpe evakuiert werden. Zweckmäßigerweise wird der Unterdruckbehälter 22 in einer obersten Position innerhalb der Kühlvorrichtung vorgesehen. Es ist dann möglich, in einer untersten Position einen freien Abfluß für eine Evakuierung anzuordnen, wenn zwischen dem Unterduckbehälter 22 und dem freien Abfluß sich innerhalb der Kühlvorrichtungen aufgrund der Leitungsführungen keine Kühlflüssigkeitssäulen aufbauen können.

Bei dem Betrieb der Kühlvorrichtung nach der Erfindung gemäß Figur 3 hat es sich als zweckmäßig erwiesen, wenn als Kühlmittel 10 Wasser Verwendung findet, dieses zu entgasen, so dass es zu keiner Blasenbildung oder dergleichen kommen kann. Zu diesem Zweck sind in dem Gasraum 24 über dem Kühlmittel 10 innerhalb des Unterdruckbehälters 22 zwei Kältepole 25,26 angeordnet, die wechselweise betrieben werden, so dass sich Feuchtigkeit dort sicher absetzen kann. Die Temperatur dieser Kältepole 25,26 sollte etwa zwischen -20°C und -30°C betragen.

Bei dem Betrieb der Kühlvorrichtung gemäß Figur 3 hat es sich ferner als zweckmäßig erwiesen, wenn die gesamte Vorrichtung vor einem Befüllen mit einem Kühlmittel 10 evakuiert wird. Einem sich anschließenden Druckaufbau, beispielsweise durch Entgasung des Kühlmittels 10 oder durch Diffusion durch das verwendete Rohrmaterial, kann durch die an den Unterdruckbehälter 22 angeschlossene Vakuumpumpe entgegengewirkt und der Unterdruck in der Vorrichtung konstant gehalten werden. Für die Evakuierung und die Füllung mit einem Kühlmittel 10 stehen hier drei Ventile 27-29 zur Verfügung.

## Patentansprüche

1. Kühlmittelgekühlte Kühlvorrichtung für Computer, Computerracks, Computerräume oder dergleichen, aufweisend wenigstens einen Kühlkreislauf für ein strömendes Kühlmittel, **dadurch gekennzeichnet, dass** in dem Kühlkreislauf (1) eine Drucksenke (5) angeordnet ist und dass der Kühlkreislauf (1) mit einem gegenüber dem Außendruck der Umgebung geringeren Arbeitsdruck beaufschlagt ist.

2. Kühlmittelgekühlte Kühlvorrichtung für Computer, Computerracks, Computerräume oder dergleichen, aufweisend wenigstens einen Kühlkreislauf für ein strömendes Kühlmittel nach Anspruch 1, **dadurch gekennzeichnet, dass** in dem Kühlkreislauf eine öffenbare Drucksenke angeordnet ist und dass die Drucksenke derart bemessen ist, dass durch sie im Fall einer Leckage des Kühlkreislaufs das Kühlmittel aus dem Kühlkreislauf abgezogen wird.

3. Kühlvorrichtung nach Anspruch 1 oder 2, **dadurch gekennzeichnet, dass** der Kühlkreislauf (1) geschlossen ist.

4. Kühlvorrichtung nach einem oder mehreren der vorangehenden Ansprüche, **dadurch gekennzeichnet, dass** der Kühlkreislauf (1) ein Sekundärkreislauf ist, dessen Wärme über einen Wärmetauscher (3) und einen Primärkreislauf (4) abgeführt wird.

5. Kühlvorrichtung nach einem oder mehreren der vorangehenden Ansprüche, **dadurch gekennzeichnet, dass** das Druckpotential der Drucksenke (5) von einer Pumpe (6) aufrecht erhalten wird.

6. Kühlvorrichtung nach einem oder mehreren der vorangehenden Ansprüche, **dadurch gekennzeichnet, dass** in dem Kühlkreislauf (1) wenigstens eine weitere Pumpe (7,8) vorgesehen ist.

7. Kühlvorrichtung nach einem oder mehreren der vorangehenden Ansprüche, **dadurch gekennzeichnet, dass** für einen Wärmeübergang von einem Computer, einem Computerrack, einem Computerraum oder dergleichen mehrere Wärmetauscher (15-17) vorgesehen sind und dass die Wärmetauscher (15-17) parallel von dem Kühlmittel (10) durchströmt werden.

8. Kühlvorrichtung nach einem oder mehreren der vorangehenden Ansprüche, **dadurch gekennzeichnet, dass** stromauf der Wärmetauscher (15-17) eine kaskadenartige Verteilvorrichtung (11) angeordnet ist.

9. Kühlvorrichtung nach einem oder mehreren der vorangehenden Ansprüche, **dadurch gekennzeichnet, dass** eine Pumpe (19) stromab der Wärmetauscher (15-17) in einem den Wärmetauschern (15-17) gemeinsamen Rücklauf (18) angeordnet ist.

10. Kühlvorrichtung nach einem oder mehreren der vorangehenden Ansprüche, **dadurch gekennzeichnet, dass** die Druckdifferenz zwischen der Umgebung und dem Kühlkreislauf zwischen 100 mbar und 300 mbar beträgt.

11. Kühlvorrichtung nach einem oder mehreren der vorangehenden Ansprüche, **dadurch gekennzeichnet, dass** der Druck in dem Kühlkreislauf unter 0,8 bar gehalten ist.

12. Kühlvorrichtung nach einem oder mehreren der vorangehenden Ansprüche, **dadurch gekennzeichnet, dass** bei einer Leckage ein Druckanstieg in dem Kühlkreislauf von einer Überwachungsvorrichtung festgestellt wird und dass von der Überwachungsvorrichtung die Pumpen stromauf des Lecks in dem Kühlkreislaufs abgeschaltet werden, die Pumpen stromab des Lecks in dem Kühlkreislauf weiterlaufen, bis das verbleibende Kühlmittel abgezogen ist.

13. Kühlvorrichtung nach einem oder mehreren der vorangehenden Ansprüche, **dadurch gekennzeichnet, dass** die Vorlauftemperatur des Kühlmittels zwischen 13°C und 15°C beträgt.

14. Kühlvorrichtung nach einem oder mehreren der vorangehenden Ansprüche, **dadurch gekennzeichnet, dass** die Rücklauftemperatur des Kühlmittels zwischen 19°C und 21°C beträgt.

15. Kühlvorrichtung nach einem oder mehreren der vorangehenden Ansprüche 1 bis 9, **dadurch gekennzeichnet, dass** die Rücklauftemperatur des Kühlmittels zwischen 40°C und 50°C beträgt.

16. Kühlvorrichtung nach einem oder mehreren der vorangehenden Ansprüche, **dadurch gekennzeichnet, dass** das Kühlmittel in einer flüssigen Phase vorliegt.

17. Kühlvorrichtung nach Anspruch 12, **dadurch gekennzeichnet, dass** das Kühlmittel entgast ist.

18. Kühlvorrichtung nach einem oder mehreren der vorangehenden Ansprüche, **dadurch gekennzeichnet, dass** in einem Gasraum (24) über dem Kühlmittel (10) innerhalb der Drucksenke (22) wenigstens ein Kältepol (25,26) angeordnet ist.

19. Kühlvorrichtung nach Anspruch 14, **dadurch gekennzeichnet, dass** zwei Kältepole (25,26) wechselweise betrieben werden.

20. Kühlvorrichtung nach einem oder mehreren der Ansprüche 14 und 15, **dadurch gekennzeichnet, dass** ein Kältepol (25,26) eine Temperatur zwischen - 20°C und - 30°C aufweist.

## Claims

1. A coolant-cooled cooling device for computers, computer racks, computer rooms and the like, comprising at least one cooling cycle for a flowing coolant, **characterised in that** a pressure sink (5) is arranged in the cooling cycle (1) and **in that** the cooling cycle (1) is acted upon by a working pressure which is lower compared to the external environmental pressure.

2. The coolant-cooled cooling device for computers, computer racks, computer rooms and the like, comprising at least one cooling cycle for a flowing coolant according to claim 1, **characterised in that** an openable pressure sink is arranged in the cooling cycle and **in that** the pressure sink is rated such that in case the cooling cycle leaks, the coolant is withdrawn from the cooling cycle.

3. The cooling device according to claim 1 or 2, **characterised in that** the cooling cycle (1) is closed.

4. The cooling device according to one or several of the preceding claims, **characterised in that** the cooling cycle (1) is a secondary cycle the heat of which is dissipated via a heat exchanger (3) and a primary cycle (4).

5. The cooling device according to one or several of the preceding claims, **characterised in that** the pressure potential of the pressure sink (5) is maintained by a pump (6).

6. The cooling device according to one or several of the preceding claims, **characterised in that** at least one further pump (7, 8) is provided in the cooling cycle (1).

7. The cooling device according to one or several of the preceding claims, **characterised in that** several heat exchangers (15 - 17) are provided for a heat transmission from a computer, a computer rack, a computer room and the like and **in that** the coolant (10) flows through the heat exchangers (15 - 17) in a parallel manner.

8. The cooling device according to one or several of the preceding claims, **characterised in that** a cascade-type distributing device (11) is arranged upstream of the heat exchangers (15 - 17).

9. The cooling device according to one or several of the preceding claims, **characterised in that** a pump (19) is arranged downstream of the heat exchangers (15 - 17) in a return (18) shared by the heat exchangers (15 - 17).

10. The cooling device according to one or several of the preceding claims, **characterised in that** the pressure difference between the environment and the cooling cycle is between 100 mbar and 300 mbar.

11. The cooling device according to one or several of the preceding claims, **characterised in that** the pressure in the cooling cycle is maintained below 0.8 bar.

12. The cooling device according to one or several of the preceding claims, **characterised in that** in case of a leak a rise in pressure in the cooling cycle is ascertained by a monitoring device and **in that** the pumps upstream of the leak in the cooling cycle are switched off by the monitoring device, while the pumps downstream of the leak in the cooling cycle continue running until the remaining coolant has been drawn off.

13. The cooling device according to one or several of the preceding claims, **characterised in that** the flow temperature of the coolant is between 13°C and 15°C.

14. The cooling device according to one or several of the preceding claims, **characterised in that** the return temperature of the coolant is between 19°C and 21°C.

15. The cooling device according to one or several of the preceding claims 1 to 9, **characterised in that** the return temperature of the coolant is between 40°C and 50°C.

16. The cooling device according to one or several of the preceding claims, **characterised in that** the coolant is present in a liquid phase.

17. The cooling device according to claim 12, **characterised in that** the coolant is degassed.

18. The cooling device according to one or several of the preceding claims, **characterised in that** at least one cold pole (25, 26) is arranged in a gas room (24) above the coolant (10) within the pressure sink (22).

19. The cooling device according to claim 14, **characterised in that** two cold poles (25, 26) are operated alternately.

20. The cooling device according to one or several of the preceding claims 14 and 15, **characterised in that** one cold pole (25, 26) has a temperature of between -20°C and -30°C.

## Revendications

1. Dispositif de refroidissement refroidi par réfrigérant pour ordinateurs, racks d'ordinateur, espaces informatiques ou similaires, présentant au moins un châssis de refroidissement pour un réfrigérant en circulation, **caractérisé en ce qu'**une descente de pression (5) est disposée dans le circuit réfrigérant (1) et **en ce que** le circuit réfrigérant (1) est alimenté avec une pression de travail plus faible par rapport à la pression extérieure de l'environnement.

2. Dispositif de refroidissement refroidi par réfrigérant pour ordinateurs, racks d'ordinateur, espaces informatiques ou similaires, présentant au moins un circuit réfrigérant pour un réfrigérant en circulation selon la revendication 1, **caractérisé en ce qu'**une descente de pression pouvant être ouverte est disposée dans le circuit réfrigérant et **en ce que** la descente de pression est dimensionnée de telle sorte que, dans le cas d'une fuite du circuit réfrigérant, le réfrigérant est sorti du circuit réfrigérant.

3. Dispositif de refroidissement selon la revendication 1 ou 2, **caractérisé en ce que** le circuit réfrigérant (1) est fermé.

4. Dispositif de refroidissement selon l'une quelconque ou plusieurs des revendications précédentes, **caractérisé en ce que** le circuit réfrigérant (1) est un circuit secondaire, dont la chaleur est évacuée au moyen d'un échangeur de chaleur (3) et d'un circuit primaire (4).

5. Dispositif de refroidissement selon l'une quelconque ou plusieurs des revendications précédentes, **caractérisé en ce que** le potentiel de pression de la descente de pression (5) est maintenu par une pompe (6).

6. Dispositif de refroidissement selon l'une quelconque ou plusieurs des revendications précédentes, **caractérisé en ce qu'**il est prévu au moins une autre pompe (7, 8) dans le circuit réfrigérant (1).

7. Dispositif de refroidissement selon l'une quelconque ou plusieurs des revendications précédentes, **caractérisé en ce que** plusieurs échangeurs de chaleur (15-17) sont prévus pour un transfert de chaleur à partir d'un ordinateur, d'un rack d'ordinateur, d'un espace informatique ou similaire et **en ce que** les échangeurs de chaleur (15-17) sont traversés parallèlement par le réfrigérant (10).

8. Dispositif de refroidissement selon l'une quelconque ou plusieurs des revendications précédentes, **caractérisé en ce qu'**un dispositif répartiteur (11) en forme de cascade est disposé en amont des échangeurs de chaleur (15-17).

9. Dispositif de refroidissement selon l'une quelconque ou plusieurs des revendications précédentes, **caractérisé en ce qu'**une pompe (19) est disposée en aval des échangeurs de chaleur (15-17) dans un retour (18) commun aux échangeurs de chaleur (15-17).

10. Dispositif de refroidissement selon l'une quelconque ou plusieurs des revendications précédentes, **caractérisé en ce que** la différence de pression entre l'environnement et le circuit réfrigérant s'élève entre 100 mbar et 300 mbar.

11. Dispositif de refroidissement selon l'une quelconque ou plusieurs des revendications précédentes, **caractérisé en ce que** la pression dans le circuit réfrigérant est maintenue au-dessous de 0,8 bar.

12. Dispositif de refroidissement selon l'une quelconque ou plusieurs des revendications précédentes, **caractérisé en ce que**, dans le cas d'une fuite, une augmentation de pression dans le circuit réfrigérant est constaté par un dispositif de contrôle et **en ce que** le dispositif de contrôle déconnecte les pompes en amont de la fuite dans le circuit réfrigérant, et les pompes continuent de fonctionner en aval de la fuite dans le circuit réfrigérant jusqu'à ce que le réfrigérant restant soit retiré.

13. Dispositif de refroidissement selon l'une quelconque ou plusieurs des revendications précédentes, **caractérisé en ce que** la température aller du réfrigérant se situe entre 13°C et 15°C.

14. Dispositif de refroidissement selon l'une quelconque ou plusieurs des revendications précédentes, **caractérisé en ce que** la température retour du réfrigérant se situe entre 19°C et 21°C.

15. Dispositif de refroidissement selon l'une quelconque ou plusieurs des revendications précédentes 1 à 9, **caractérisé en ce que** la température retour du réfrigérant se situe entre 40°C et 50°C.

16. Dispositif de refroidissement selon l'une quelconque ou plusieurs des revendications précédentes, **caractérisé en ce que** le réfrigérant est présent dans une phase liquide.

17. Dispositif de refroidissement selon la revendication 12, **caractérisé en ce que** le réfrigérant est dégazé.

18. Dispositif de refroidissement selon l'une quelconque ou plusieurs des revendications précédentes, **caractérisé en ce qu'**au moins un pôle frigorifique (25, 26) est disposé dans un espace de gaz (24) au-dessus du réfrigérant (10) à l'intérieur de la descente de pression (22).

19. Dispositif de refroidissement selon la revendication 14, **caractérisé en ce que** deux pôles frigorifiques (25, 26) sont exploités en alternance.

20. Dispositif de refroidissement selon l'une quelconque ou plusieurs des revendications 14 et 15, **caractérisé en ce qu'**un pôle frigorifique (25, 26) présente une température comprise entre -20°C et -30°C.
